# EUROPEAN PATENT SPECIFICATION

(11) **EP 1 437 036 B1**
(45) Date of publication and mention of the grant of the patent: **17.02.2010**
(21) Application number: 02775816.8
(22) Date of filing: 16.09.2002
(51) Int. Cl.: H05K 3/02

(54) **LATCHING MICRO MAGNETIC RELAY PACKAGES AND METHODS OF PACKAGING**
KAPSELUNG FUER POLARISIERTES MEMS RELAIS UND VERFAHREN ZUR KAPSELUNG
BOITIERS DE RELAIS A VERROUILLAGE MICROMAGNETIQUES ET PROCEDES D'ENCAPSULATION ASSOCIES

(30) Priority: 17.09.2001 US 322841 P; 19.04.2002 US 126291
(43) Date of publication of application: 14.07.2004
(73) Proprietor: Stafford, John, Phoenix, AR 85048 (US); Tam, Gordon, Gilbert, AZ 85296 (US); Shen, Jun, Phoenix, AZ 85048 (US)
(72) Inventor: Stafford, John, Phoenix, AR 85048 (US); Tam, Gordon, Gilbert, AZ 85296 (US); Shen, Jun, Phoenix, AZ 85048 (US)
(74) Representative: Johnstone, Helen Margaret
(86) International application number: PCT/US2002/029279
(87) International publication number: WO 2003/026369

(56) References cited:
- EP-A1- 0 869 519
- WO-A-98/06118
- WO-A2-01/56920
- US-A- 5 837 935
- US-A- 6 057 520
- US-A- 6 140 144

## Description

### TECHNICAL FIELD

This invention relates to latching micro magnetic relays.

More particularly, the present invention relates to methods of packaging latching micro magnetic relays and the various packages.

### BACKGROUND ART

Recently, novel latching micro magnetic relays were discovered. The novel latching micro magnetic relay is based on preferential magnetization of a soft magnetic cantilever in a permanent external magnetic field. Switching between two magnetic states is accomplished by momentarily changing the direction of the cantilever's magnetization by passing a short current pulse through a planar coil situated adjacent the cantilever. Once the relay is switched, it is held in this nonvolatile state (latched) by the permanent external magnetic field. Additional information as to the construction and operation of the novel latching micro magnetic relay is disclosed in a copending United States patent application entitled "Electronically Switching Latching Micro-Magnetic Relay and Method of Operating Same", with serial number 09/496,446, filing date 02 February 2000. While a specific latching micro magnetic relay is described above, it will be understood that other Micro Electro Mechanical Systems (MEMS) devices that incorporate magnets are also included in this description.

In the prior art, the cantilever for micro magnetic switches was fabricated as a complete portion of the switch by providing a sacrificial layer of photoresist, depositing the material of the cantilever on the surface of the photoresist and then etching or otherwise dissolving the photoresist layer to provide a cantilever. One problem with this prior art method is that any process steps performed subsequent to the application of the photoresist layer are seriously limited because of potential damage to the photoresist material and, thus, potential faults or weaknesses in the final product.

Also, in most prior art packaging techniques relatively high temperatures are required for some of the later steps. These high temperatures can seriously affect magnets and some of the other components enclosed in the packages. Further, the materials that could be used as the supporting substrate for the MEMS devices is seriously limited by the fabrication and packaging techniques.

One type of prior art package for a MEMS (micro-electromechanical system) device is disclosed in International Publication Number WO 01/56920 A2, dated 9 August 2001. Briefly, this device includes a substrate with a cantilever integrally formed thereon. A plurality of conductively filled vias extend through the substrate with one of the vias forming an electrical connection to the cantilever and one forming a contact to be engaged by the cantilever in one orientation. A cap is formed to cover the cantilever and contact. The edges of the cap are sealed to the substrate in one embodiment by alloy bonding or simply sealed by epoxy in another embodiment.

It would be highly advantageous, therefore, to remedy the foregoing and other deficiencies inherent in the prior art.

Accordingly, it is an object the present invention to provide a new and improved latching micro magnetic relay and package.

Another object of the present invention is to provide a new and improved latching micro magnetic relay package that can be fabricated on a GaAS substrate.

Another object of the present invention is to provide a new and improved latching micro magnetic relay package that is easy and inexpensive to manufacture.

A further object of the present invention is to provide a new and improved latching micro magnetic relay package fabricated with low temperature assembly.

Still another object of the present invention is to provide a new and improved latching micro magnetic relay package that can be hermetically sealed on any of a variety of improved substrates using relatively low temperature.

### DISCLOSURE OF THE INVENTION

Briefly, to achieve the desired objects of the present invention in accordance with the claims. provided is a method of forming a package and sealing a MEMS device in the package including the steps of providing a supporting substrate, forming at least one contact for the MEMS device on the surface of the supporting substrate and providing an external connection to the contact, forming a cantilever on the surface of the supporting substrate, the cantilever being positioned to come into electrical engagement with the contact in one orientation, and depositing a seal ring on the surface of the supporting substrate circumferentially around the contact and the cantilever. The method further includes the steps of forming a cap member with a cavity and a continuous edge circumferentially around the cavity, the cavity being designed to receive the cantilever and contact therein, and depositing a seal ring on the continuous edge of the cap member. The package is then sealed by sealingly engaging the seal ring on the continuous edge of the cap member to the seal ring on the surface of the supporting substrate.

The sealed package includes a supporting substrate with a surface, at least one contact for the MEMS device on the surface of the supporting substrate with an external connection to the contact and a cantilever on the surface of the supporting substrate, the cantilever being positioned to come into electrical engagement with the contact in one orientation. A metal seal ring is fixed on the surface of the supporting substrate circumferentially around the contact and the cantilever. A cap member is formed with a cavity and a continuous edge circumferentially around the cavity. The cavity is designed to receive the cantilever and contact therein with the continuous edge in mating engagement with the metal seal ring on the surface of the supporting substrate. A metal seal ring is fixed on the continuous edge of the cap member. The metal seal ring on the continuous edge of the cap member is sealingly engaged with the metal seal ring on the surface of the supporting substrate. The two metal seal rings are sealingly engaged or fixed together by a solder alloy that is reflowed in an inert environment without the use of flux.

### BRIEF DESCRIPTION OF THE DRAWINGS

The foregoing and further and more specific objects and advantages of the invention will become readily apparent to those skilled in the art from the following detailed description of a preferred embodiment thereof, taken in conjunction with the drawings in which:
FIG. 1 is a simplified sectional view illustrating one embodiment of a wafer scale packaging process for a latching micro magnetic relay;
FIG. 2 is a view in top plan of a pair of wafer as used in the present invention;
FIG. 3 is a simplified sectional view of the wafers of FIG. 2 in alignment, prior to bonding;
FIG. 4 is a more detailed and enlarged sectional view of the wafers of FIG. 2 in alignment, prior to bonding;
FIG. 5 is a more detailed and enlarged sectional view of the wafers of FIG. 4 in alignment, subsequent to bonding;
FIG. 6 is a view in top plan of a portion of the bonded wafers prior to dicing;
FIG. 7 is and enlarged sectional view of a single package after dicing; and
FIG. 8 is a simplified sectional view illustrating portions of another embodiment of a wafer scale packaging process for a latching micro magnetic relay.

### BEST MODES FOR CARRYING OUT THE INVENTION

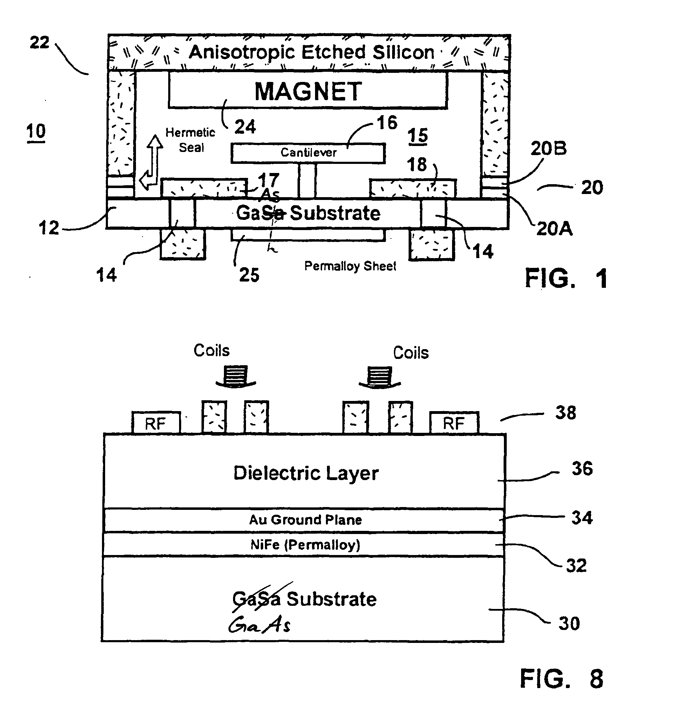

Turning now to FIG. 1, a wafer scale package 10 is illustrated for a latching micro magnetic relay or other MEMS structures incorporating a magnet or other heat sensitive components. As will be described in more detail below, one major advantage of package 10 is that it can be assembled using solder preforms and low temperature assembly. Low temperature assembly is desirable because the magnet incorporated in the MEMS structure can easily be damaged by too much heat.

As will become apparent from the discussion below, package 10 can be fabricated in wafer format and does not require the assembly of the MEMS devices individually into individual packages. As described in conjunction with the above structure, a plurality of MEMS devices are generally formed simultaneously on a single wafer. If the wafer must be separated into individual MEMS devices and each individual device packaged separately, the labor cost becomes very high.

In this invention, a GaAs substrate 12 is used instead of silicon, glass, quartz, or any other convenient material that provides the desired characteristics, such as any of the well known semiconductor material, such as silicon, gallium arsenide, etc., or it can include quartz ceramics, various organic or magnetic materials, etc. Generally, as will be understood by those skilled in the art, a GaAs substrate is preferred because the material provides substantial benefits at higher frequencies. However, the art of silicon processing has developed to a very advanced state in the semiconductor field and is, therefore, very useful in the present invention. Also, in some specific applications, cooperating or externally connected circuitry can be formed directly on the same substrate to reduce connection losses. As will be explained in more detail presently, substrate 12 is generally included as a small portion of a much larger wafer, the individual packages 10 being separated only after substantial portions of the fabrication are completed.

In this preferred embodiment, a pair of vias 14 are provided in substrate 12 and can be formed by any of a variety of well known processes including etching, laser drilling, etc. Generally, the method of formation of vias 14 is determined by the cost of the different procedures. Also, vias 14 are plugged or filled with a conductive material. Technology for plugging or filling vias 14 in GaAs, silicon, or glass exists and will not be elaborated upon in this disclosure. The lower or external portions of vias 14 are barrier plated for solderability to allow solder bumping or direct solder attachment to a printed wiring board, ceramic board, etc. Also, the lower or external portions of vias 14 form an I/O interface which in the finished format allow for the clearance of the finished package off the surface of a mounting board (not shown).

In general, once vias 14 in substrate 12 are plugged, fabrication of a MEMS device 15 on substrate 12 proceeds in a normal fashion. Because virtually any type of MEMS device can be incorporated into package 10, MEMS device 15 is represented in FIG. 1, simply by a cantilever 16 positioned to provide a contact between spaced apart conductive pads 17 and 18 in an activated state. A hermetic seal ring 20A is positioned around each MEMS device 15 on the wafer (substrate 12). Because a plurality of packages 10 are formed simultaneously on a common wafer, seal rings 20A are all patterned on the wafer surface using common patterning steps.

Seal ring 20A is preferrably metallized onto the surface of wafer 12 and generally includes a thin portion or layer (an adhesion layer) of material or metal that adheres well to wafer 12 (e.g. tungsten, titanium, or combinations thereof) and a thicker portion or layer (a sealing layer) of a sealing or junction material, e.g., nickel/gold, chrome/gold, etc. Generally, at least a 0.5 mm seal ring 20A around each MEMS device 15 is provided for a hermetic seal. Also, provisions are included for a saw kerf between adjacent die when the wafer is separated into individual packages. A disadvantage is that seal ring 20A and the saw kerf use substantial wafer area, but various procedures and alterations may be incorporated to minimize this problem.

A silicon wafer is provided to form a hermetic cap 22 to be incorporated with a seal ring 20B. While a single cap 22 is illustrated it will be understood that a number of caps will be formed in the silicon wafer equal to the number of MEMS devices formed in the GaAs wafer. Again it will be understood that hermetic cap 22 could be formed from other material, such as glass, ceramic, etc. but silicon is used in this preferred embodiment because of the vast knowledge and machinery available for working with silicon. Anisotropic etching of vias, holes grooves, etc. in silicon wafers is a reasonably well understood process.

A silicon wafer of the right thickness to house a magnet 24 and to clear cantilever 16 of MEMS device 15 is selected. Holes, e.g. circular, square, etc., are etched in the silicon wafer on a precise pitch. The precise pitch is of course the same pitch used to form MEMS devices 15 and seal rings 20A on the GaAS wafer (substrate 12). Seal ring 20B is metallized on the lower lips of each cap 22 and formed generally as described for seal ring 20A above. To allow a hermetic sealing of cap 22 to substrate 12 an 80/20 Au/Sn preform is tack welded to either metallized seal ring, that is seal ring 20A on substrate 12 or seal ring 20B on cap 22. In another method, 80/20 Au/Sn alloy can be plated on seal ring 20B of cap 22. In this procedure, plating the alloy on the seal ring is believed to be more variable than using a tacked preform.

At any convenient time during the fabrication, a magnet 24 is aligned and bonded (e.g. by epoxy or other suitable adhesive) into the cavity in each cap 22 of the silicon wafer. To this end, using machine vision allows magnets 24 to be precisely placed in the center of each cavity. It will be understood that, in some specific applications, magnet 24 can be placed outside of the package, if desired.

The anisotropically etched caps 22 on the silicon wafer are aligned to the MEMS device on the GaAs wafer and hermetically sealed by reflowing the 80/20 Au/Sn alloy in an inert environment without the use of any flux. Thus, metal seal ring 20A and metal seal ring 20B are affixed together to form a compound seal ring 20. An appropriate fiducial/alignment scheme can be developed for the wafers to ensure each magnet 24 is aligned to within +/- .001" of the center of each and every MEMS device 15.

The coefficient of thermal expansion of silicon is 2.3 - 4.7 (ppm/C) and for GaAs is 5.4 - 5.72 (ppm/C). There thus would be a minimal mismatch in the coefficient of thermal expansion of about 2 (ppm/C). The consequence of this mismatch is that if stress problems arise in specific application, an Au/Sn alloy which is some what more tin rich could be used to provide the stress relief. In applications where the substrate and cap are formed of similar material thermal expansion is not a problem. The use of other lower temperature solder is possible in all cases as long as fluxless soldering processes are used.

While the above structure provides a complete hermetic seal for the micro magnetic relay or other MEMS structure, it will be understood that in some applications such hermeticity is or may not be required. Thus, in such applications instead of the metal seal rings and/or the solder, the cap may simply be epoxied or otherwise adhered to the substrate or the seal rings may be epoxied or adhered together.

Finally, a permalloy backing sheet 25 (magnetic flux concentrator) is bonded to the I/O side of the hermetically sealed wafer scale package 10. Permalloy backing sheet 25 is preferrably of a grillage format to allow bonding of all sites (i.e. all packages 10 on the GaAs wafer) at once. The exposed surface of permalloy backing sheet 25 preferrably is provided with an organic dielectric coating. The dielectric coating ensures that no electric paths develop between the external portions of vias 14 or any conductors on the surface of the mounting board. The bonded side of permalloy backing sheet 25 preferrably has a pressure sensitive thermally cureable adhesive thereon. By supplying a pressure sensitive adhesive on permaloy backing sheet 25 assembly can be accomplished very easily.

Generally, an advantage of wafer scale packages 10 is that they can be tested in wafer format (i.e. before separation into individual parts) and then the wafer can be solder bumped if desired. The wafer is then sawn, or otherwise separated, to provide singulated components. Alternatively, the wafer could be sawn to provide singulated components and then tested and individually solder bumped if desired. Implicit in this procedure is that the wafer die yield is very high (approximately +98%).

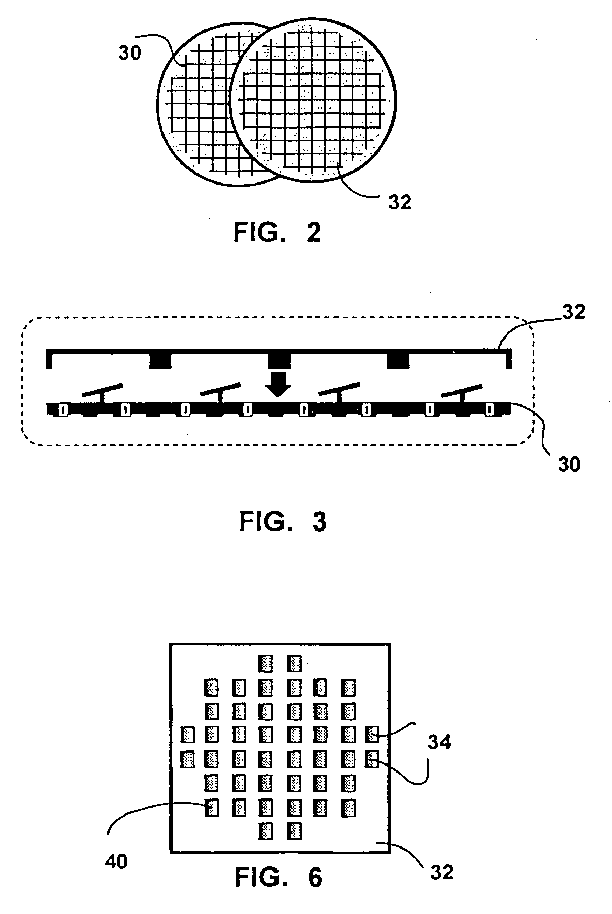

Turning now to FIG. 2, a pair of wafers 30 and 32 (device and encapsulation wafers, respectively) are provided. Here it will be understood that wafers 30 and 32 can include any of the well known semiconductor material, such as silicon, gallium arsenide, etc., or they can include quartz ceramics, various organic or magnetic materials, etc. Referring additionally to FIG. 3, it can be seen that an array of latching micro magnetic relays or other MEMS structures are formed on wafer 30 and a similar array of caps are formed in wafer 32. Wafers 30 and 32 are axially aligned in overlying relationship so that a cap in wafer 32 overlies each latching micro magnetic relay or other MEMS structure on wafer 30.

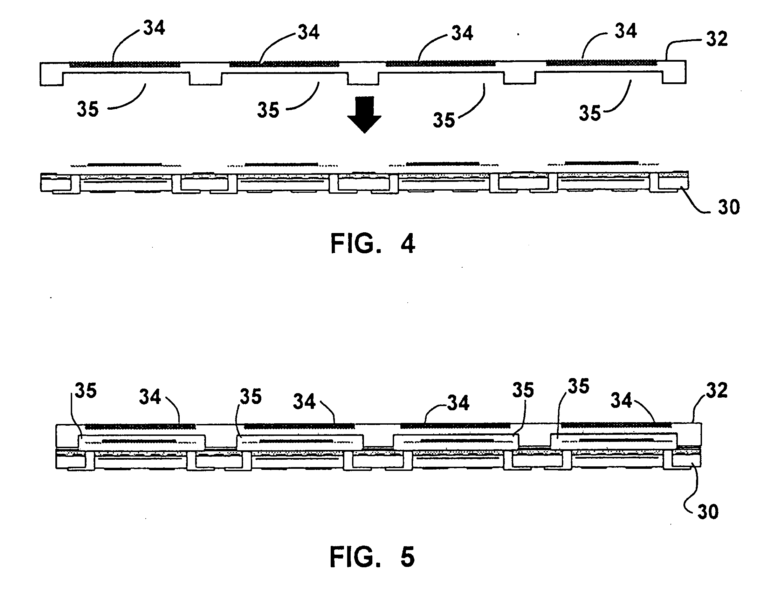

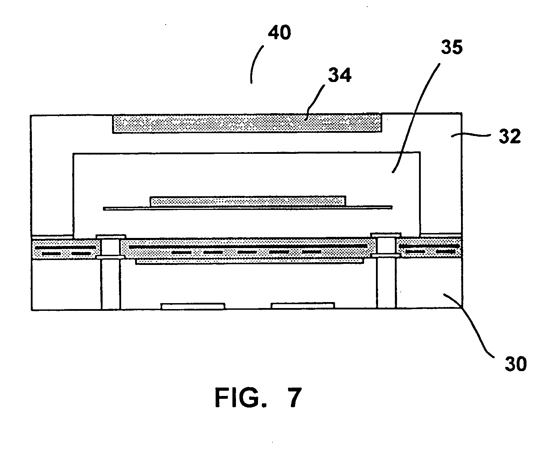

Referring additionally to FIG. 4, an enlarged more detailed sectional view is illustrated of wafers 30 and 32. From this view it can be seen that magnets 34 are positioned in the upper surface of wafer 32 and aligned, one each, with cavities 35 in the lower surface of wafer 32. Wafers 30 and 32 are then brought together and bonded, as illustrated in FIG. 5. Thus, an array of wafer scale packages are manufactured simultaneously in wafers 30 and 32, as illustrated in FIG. 6. The bonded wafers are then diced, or otherwise separated into a plurality of wafer scale packages. A single one of the wafer scale packages, designated 40, is illustrated in an enlarged sectional view in FIG. 7. The individual packages can be tested before dicing and/or after dicing if desired.

Turning now to FIG. 8, one way to save some of the area required for hermetically sealing wafer scale MEMS package 10 is illustrated. In this procedure, the package is modified from a single plane layout to a multilayer layout. In the multilayer layout of FIG. 8 the structure includes a substrate 30, a permalloy layer 32, a ground plane 34, an insulating dielectric layer 36, and a layer 38 for RF routing and coils. Here it is also assumed the MEMS cantilever (not shown) is mounted in the same plane as the RF lines. Ground plane 34 is formed of electrically conductive but non-magnetic material (e.g. gold or the like) so as not to reduce the effects of permalloy layer 32. Also, capacitance coupling effects can be mitigated by controlling the thickness of dielectric layer 36.

The structure described above can save wafer space but will include additional mask layers and fabrication steps. A polymer dielectric that can be used in lieu of polyimide and has RF potential because of its low loss, is Dow Chemical's benzocyclobutene (BCB). This material has been used extensively for high density interconnects in multi chip modules. Another possible high frequency dielectric that can be used is one of the formulations of nitride which is inorganic.

Thus, a new and improved latching micro magnetic relay or MEMS package has been disclosed, which is highly adaptable and easy to manufacture. Also, the improved package and methods of fabrication can incorporate a variety of different supporting substrates. Further, a variety of different caps can be easily fabricated and applied to the substrate using low temperature processes. Because the preferred manufacturing process contemplates the simultaneous fabrication of a plurality of packages on a single wafer, the packages can be tested at various points during the manufacturing process and defective packages can be eliminated before too much time and resources are expended.

Various changes and modifications to the embodiments herein chosen for purposes of illustration will readily occur to those skilled in the art and are intended to be included within the scope of the invention, which is assessed only by a fair interpretation of the following claims.

Having fully described the invention in such clear and concise terms as to enable those skilled in the art to understand and practice the same, the invention claimed is:

## Claims

1. A method of forming a package (10) and sealing a latching micro magnetic relay device (15) in the package (10) comprising the steps of:
providing a supporting GaAS substrate (12) with a surface;
forming at least one contact (17, 18) for the latching micro magnetic relay device (15) on the surface of the supporting substrate (12) and providing an external connection (14) to the contact (12);
forming a cantilever (16) on the surface of the supporting substrate (12), the cantilever (16) being positioned to come into electrical engagement with the contact (17, 18) in one orientation;
depositing a steal ring (20A) on the surface of the supporting substrate (12) circumferentially around the contact (17, 18) and the cantilever (16);
forming a cap member (22) with a cavity and a continuous edge circumferentially around the cavity, the cavity being designed to receive the cantilever (16) and contact (17, 18) therein;
depositing a seal ring (20B) on the continuous edge of the cap member (22); and
sealingly engaging the seal ring (20B) on the continuous edge of the cap member (22) to the seal ring (20A) on the surface of the supporting substrate (12).
wherein the method comprises the further steps of : attaching a permalloy member (25) to the supporting substrate (12); and attaching a magnet (24) to the cap member (22).

2. A method as claimed in claim 1 wherein the step of forming at least one contact (17, 18) includes forming at least one via (14) through the supporting substrate (12) and distributing conductive material through the via (14).

3. A method as claimed in claim 1 wherein the step of providing the external connection (14) to the contact (17, 18) includes plating a metal on a lower end of the via (14), the metal being selected for solderability and formed for package clearance.

4. A method as claimed in claim 1 wherein the step of forming the cap member (22) includes forming a cap member (22) of one of GaAs, glass, silicon, quartz, ceramic, organic material, and magnetic material.

5. A method as claimed in claim 4 wherein the step of forming the cap member (22) includes forming a cap member (22) of silicon and forming the cavity by anisotropically etching the silicon.

6. A method as claimed in claim 1 wherein the steps of depositing the seal rings (20A; 20B) on the surface of the supporting substrate (12) and on the continuous edge of the cap member (22) each include depositing an adhesion portion and a sealing portion.

7. A method as claimed in claim 6 wherein the step of depositing the adhesion portion includes depositing one of tungsten, titanium, and combinations thereof.

8. A method as claimed in claim 6 wherein the step of depositing the sealing portion includes depositing one of nickel, gold, chrome, and alloys thereof.

9. A method as claimed in claim 1 wherein the step of sealingly engaging the seal ring (20B) on the continuous edge of the cap member (22) to the seal ring (20A) on the surface of the supporting substrate (12) includes a step of affixing a solder alloy to one of the seal ring (20B) on the continuous edge of the cap member (22) and the seal ring (20A) on the surface of the supporting substrate (12).

10. A method as claimed in claim 9 wherein the step of affixing a solder alloy includes affixing a solder alloy of 80/20 Au/Sn.

11. A method as claimed in claim 9 wherein the step of sealingly engaging further includes the step of reflowing the solder alloy without the use of flux.

12. A method as claimed in claim 9 wherein the step of sealingly engaging further includes the step of hermetically sealing the package (10) by reflowing the solder alloy in an inert environment without the use of flux.

13. A package (10) with a latching micromagnetic relay device (15) hermetically sealed in the package comprising:
a supporting GaAs substrate (12) with a surface;
at least one contact (17, 18) for the latching micromagnetic relay device (15) on the surface of the supporting substrate (12) with an external connection (14) to the contact (17, 18) and a cantilever (16) on the surface of the supporting substrate (12), the cantilever (16) being positioned to move into electrical engagement with the contact (17, 18) in one orientation;
a metal seal ring (20A) fixed on the surface of the supporting substrate (12) circumferentially around the contact (17, 18) and the cantilever (16), the seal ring (20A) including an adhesion portion and a sealing portion;
a siliconchip forming a cap member (22) with a cavity and defining a cavity with a continuous edge circumferentially around the cavity, the cavity being designed to receive the cantilever (16) and contact (17, 18) therein
a metal seal ring (20B) fixed on the continuous edge of the cap member (22), the metal seal ring (20B) including an adhesion portion and a sealing portion
a magnet (24) affixed to the cap member (22); and
a solder alloy sealingly engaging the metal seal ring (20B) on the continuous edge of the cap member (22) to the metal seal ring (20A) on the surface of the supporting substrate (12).

14. A sealed package as claimed in claim 13 wherein the adhesion portion includes one of tungsten, titanium, and combinations thereof.

15. A sealed package as claimed in claim 13 wherein the sealing portion includes one of nickel, gold, chrome, and alloys thereof.

16. A sealed package as claimed in claim 13 wherein the solder alloy includes a solder alloy of 80/20 Au/Sn.

17. A package as claimed in claim 13 wherein the package is hermetically sealed by reflowing the solder alloy in an inert environment without the use of flux.

## Patentansprüche

1. Verfahren zur Ausbildung einer Gehäuses (10) oder einer Verpackung und zur Abdichtung eines mikro-magnetischen Stromstoß- oder Stützrelais-Geräts oder MEMS-Geräts (engl.: "latching micro magnetic relay device"; im Folgenden nur: "Gerät") in dem Gehäuse (10) mit folgenden Verfahrensschritten:
Bereitstellen eines abstützenden GaAs-Substrats (12) mit einer Oberfläche;
Ausbildung zumindest eines Kontakts (17, 18) für das Gerät (15) auf der Oberfläche des abstützenden Substrats (12) und Bereitstellung einer externen Verbindung (14) mit dem Kontakt (12);
Ausbildung eines Trägers oder Auslegers (16) auf der Oberfläche des abstützenden Substrats (12), wobei der Träger oder Ausleger (16) geeignet positioniert ist, so dass dieser in einer Orientierung oder Betriebsstellung in elektrische Wechselwirkung mit dem Kontakt (17, 18) kommen kann;
Anordnung eines Dichtrings (20A), der den Kontakt (17, 18) und den Träger oder Ausleger (16) in Umfangsrichtung umgibt, auf der Oberfläche des abstützenden Substrats (12);
Ausbildung eines Kappen-Elements (22) mit einer Kavität und einem in Umfangsrichtung um die Kavität kontinuierlichen Rand, wobei die Kavität geeignet gestaltet ist, um den Träger oder Ausleger (16) und den Kontakt (17, 18) aufzunehmen;
Anordnen eines Dichtrings (20B) auf dem kontinuierlichen Rand des Kappen-Elements (22); und
Ausbildung einer abdichtenden Wechselwirkung des Dichtrings (20B) auf dem kontinuierlichen Rand des Kappen-Elements (22) mit dem Dichtring (20A) auf der Oberfläche des abstützenden Substrats (12),
wobei das Verfahren die weiteren folgenden Verfahrensschritte aufweist:
Befestigung eines Permalloy-Elements (25) an dem abstützenden Substrat (12); und
Befestigung eines Magneten (24) an dem Kappen-Element (22).

2. Verfahren nach Anspruch 1, **dadurch gekennzeichnet, dass** der Verfahrensschritt einer Ausbildung zumindest eines Kontakts (17, 18) das Ausbilden von zumindest einem Weg (14) durch das abstützende Substrat (12) und Verteilen oder Verlegen leitenden Materials durch den Weg (14) aufweist.

3. Verfahren nach Anspruch 1, **dadurch gekennzeichnet, dass** der Verfahrensschritt einer Bereitstellung einer externen Verbindung (14) zu dem Kontakt (17, 18) ein Bilden einer Auflage, eines Überzugs oder einer Beschichtung eines Metalls auf einem unteren Ende des Weges (14) beinhaltet, wobei das Metall ausgewählt hinsichtlich der Lötbarkeit und geeignet geformt wird für ein Gehäuse-Spiel.

4. Verfahren nach Anspruch 1, **dadurch gekennzeichnet, dass** der Verfahrensschritt der Ausbildung des Kappen-Elementes (22) die Ausbildung eines Kappen-Elements (22) aus einem der Materialien GaAs, Glas, Silikon, Quarz, Keramik, organischem Material und magnetischem Material aufweist.

5. Verfahren nach Anspruch 4, **dadurch gekennzeichnet, dass** der Verfahrensschritt der Ausbildung des Kappen-Elements (22) die Ausbildung eines Kappen-Elements (22) aus Silikon aufweist und die Ausbildung der Kavität durch anisotropisches Ätzen oder Abtragen des Silikons erfolgt.

6. Verfahren nach Anspruch 1, **dadurch gekennzeichnet, dass** die Verfahrensschritte der Anordnung der Dichtringe (20A; 20B) auf der Oberfläche des abstützenden Substrats (12) und auf dem kontinuierlichen Rand des Kappen-Elements (22) jeweils das Anordnen eines Adhäsions-Bereichs und eines Dicht-Bereichs aufweisen.

7. Verfahren nach Anspruch 6, **dadurch gekennzeichnet, dass** der Verfahrensschritt der Anordnung des Adhäsions-Bereichs ein Anordnen von Wolfram und/oder Titan beinhaltet.

8. Verfahren nach Anspruch 6, **dadurch gekennzeichnet, dass** der Verfahrensschritt des Anordnens des abdichtenden Bereichs ein Anordnen von Nickel, Gold, Chrom oder eine Legierung der genannten Materialen aufweist.

9. Verfahren nach Anspruch 1, **dadurch gekennzeichnet, dass** der Verfahrensschritt der Erzeugung der abdichtenden Wechselwirkung des Dichtrings (20B) auf dem kontinuierlichen Rand des Kappen-Elements (22) mit dem Dichtring (20A) auf der Oberfläche des abstützenden Substrats (12) einen Verfahrensschritt einer Befestigung einer Lötlegierung an dem Dichtring (20B) auf dem kontinuierlichen Rand des Kappen-Elements (22) und/oder dem Dichtring (20A) auf der Oberfläche des abstützenden Substrats (12) beinhaltet.

10. Verfahren nach Anspruch 9, **dadurch gekennzeichnet, dass** der Verfahrensschritt des Befestigens einer Lötlegierung ein Befestigen einer 80/20 - Au/Sn - Lötlegierung beinhaltet.

11. Verfahren nach Anspruch 9, **dadurch gekennzeichnet, dass** der Verfahrensschritt der Erzeugung einer abdichtenden Wechselwirkung weiterhin den Verfahrensschritt eines Erzeugens eines Rückflusses oder eines Schmelzens der Lötlegierung ohne Einsatz eines Flussmittels beinhaltet.

12. Verfahren nach Anspruch 9, **dadurch gekennzeichnet, dass** der Verfahrensschritt einer Erzeugung einer abdichtenden Wechselwirkung weiterhin den Verfahrensschritt einer hermetischen Abdichtung des Gehäuses (10) durch Rückfluss oder Schmelzen der Lötlegierung in einer inerten Umgebung ohne Einsatz eines Flussmittels beinhaltet.

13. Gehäuse (10) oder Verpackung mit einem mikro-magnetischen Stromstoß- oder Stützrelais-Gerät oder MEMS-Gerät (10) (engl.: "latching micro magnetic relay device"; im Folgenden nur: "Gerät"), welches hermetisch in dem Gehäuse abgedichtet ist mit:
einem abstützenden GaAs-Substrat (12) mit einer Oberfläche;
zumindest einem Kontakt (17, 18) für das Gerät (15) auf der Oberfläche auf dem abstützenden Substrat (12) mit einer externen Verbindung (14) zu dem Kontakt (17, 18) und einem Träger oder Ausleger (16) auf der Oberfläche des abstützenden Substrats (12), wobei der Ausleger oder Träger (16) derart positioniert ist, dass sich dieser in elektrische Wechselwirkung mit dem Kontakt (17, 18) in eine Orientierung oder Betriebsstellung bewegen kann;
einem metallischen Dichtring (20A), der in Umfangsrichtung um den Kontakt (17, 18) und um den Ausleger oder Träger (16) auf der Oberfläche des abstützenden Substrats (12) befestigt ist, wobei der Dichtring (20A) einen Adhäsions-Bereich und einen Dicht-Bereich besitzt;
einem Silikonchip, der ein Kappen-Element (22) mit einer Kavität ausbildet und eine oder die Kavität mit einem kontinuierlichen Rand in Umfangsrichtung um die Kavität bildet, wobei die Kavität geeignet gestaltet ist, um den Ausleger oder Träger (16) und den Kontakt (17, 18) aufzunehmen;
einem metallischen Dichtring (20B), der an oder auf dem kontinuierlichen Rand des Kappen-Elements (22) befestigt ist, wobei der metallische Dichtring (20B) einen Adhäsions-Bereich und einen Dicht-Bereich besitzt;
einem Magnet (24), der an dem Kappen-Element (22) befestigt ist; und
einer Lötlegierung, die eine abdichtende Wechselwirkung des metallischen Dichtrings (20B) auf dem kontinuierlichen Rand des Kappen-Elements (22) mit dem metallischen Dichtring (20A) auf der Oberfläche des abstützenden Substrats (12) erzeugt.

14. Gehäuse nach Anspruch 13, **dadurch gekennzeichnet, dass** der Adhäsions-Bereich Wolfram und/oder Titan aufweist.

15. Gehäuse nach Anspruch 13, **dadurch gekennzeichnet, dass** der abdichtende Bereich Nickel, Gold, Chrom oder eine Legierung der genannten Materialien aufweist.

16. Gehäuse nach Anspruch 13, **dadurch gekennzeichnet, dass** die Lötlegierung eine 80/20 - Au/Sn - Lötlegierung aufweist.

17. Gehäuse nach Anspruch 13, **dadurch gekennzeichnet, dass** das Gehäuse hermetisch abgedichtet ist durch Rückfluss oder Schmelzen der Lötlegierung in einer inerten Umgebung ohne Einsatz eines Flussmittels.

## Revendications

1. Procédé pour former un emballage (10) et sceller un dispositif formant relais micromagnétique de verrouillage (15) dans l'emballage (10) comprenant les étapes consistant à :
prévoir un substrat de support à base d'arséniure de gallium (12) avec une surface ;
former au moins un contact (17, 18) pour le dispositif formant relais micromagnétique de verrouillage (15) sur la surface du substrat de support (12) et prévoir un raccordement externe (14) sur le contact (12) ;
former un porte-à-faux (16) sur la surface du substrat de support (12), le porte-à-faux (16) étant positionné pour venir en mise en prise électrique avec le contact (17, 18) dans une orientation ;
déposer une bague d'étanchéité (20A) sur la surface du substrat de support (12) de manière circonférentielle autour du contact (17, 18) et du porte-à-faux (16) ;
former un élément de capuchon (22) avec une cavité et un bord continu de manière circonférentielle autour de la cavité, la cavité étant conçue pour recevoir le porte-à-faux (16) et le contact (17, 18) à l'intérieur de celle-ci ;
déposer une bague d'étanchéité (20B) sur le bord continu de l'élément de capuchon (22) ; et
mettre en prise de manière étanche la bague d'étanchéité (20B) sur le bord continu de l'élément de capuchon (22) avec la bague d'étanchéité (20A) sur la surface du substrat de support (12) ;
dans lequel le procédé comprend les étapes supplémentaires consistant à :
fixer un élément en Permalloy (25) sur le substrat de support (12) ; et
fixer un aimant (24) sur l'élément de capuchon (22).

2. Procédé selon la revendication 1, dans lequel l'étape consistant à former au moins un contact (17, 18) comprend l'étape consistant à former au moins un trou d'interconnexion (14) à travers le substrat de support (12) et répartir un matériau conducteur à travers le trou d'interconnexion (14).

3. Procédé selon la revendication 1, dans lequel l'étape consistant à prévoir le raccordement externe (14) sur le contact (17, 18) comprend l'étape consistant à plaquer un métal sur une extrémité inférieure du trou d'interconnexion (14), le métal étant sélectionné pour la soudabilité et formé pour le jeu d'emballage.

4. Procédé selon la revendication 1, dans lequel l'étape consistant à former l'élément de capuchon (22) comprend l'étape consistant à former un élément de capuchon (22) avec l'un parmi l'arséniure de gallium, le verre, le silicium, le quartz, la céramique, un matériau organique et un matériau magnétique.

5. Procédé selon la revendication 4, dans lequel l'étape consistant à former l'élément de capuchon (22) comprend l'étape consistant à former un élément de capuchon (22) en silicium et l'étape consistant à former la cavité en gravant de manière anisotrope le silicium.

6. Procédé selon la revendication 1, dans lequel les étapes consistant à déposer les bagues d'étanchéité (20A ; 20B) sur la surface du substrat de support (12) et sur le bord continu de l'élément de capuchon (22), comprennent chacune l'étape consistant à déposer une partie d'adhésion et une partie d'étanchéité.

7. Procédé selon la revendication 6, dans lequel l'étape consistant à déposer la partie d'adhésion comprend l'étape consistant à déposer l'un parmi le tungstène, le titane et leurs combinaisons.

8. Procédé selon la revendication 6, dans lequel l'étape consistant à déposer la partie d'étanchéité comprend l'étape consistant à déposer l'un parmi le nickel, l'or, le chrome et leurs alliages.

9. Procédé selon la revendication 1, dans lequel l'étape consistant à mettre en prise de manière étanche la bague d'étanchéité (20B) sur le bord continu de l'élément de capuchon (22), avec la bague d'étanchéité (20A) sur la surface du substrat de support (12) comprend une étape consistant à fixer un alliage de soudure sur l'un parmi la bague d'étanchéité (20B) sur le bord continu de l'élément de capuchon (22) et la bague d'étanchéité (20A) sur la surface du substrat de support (12).

10. Procédé selon la revendication 9, dans lequel l'étape consistant à fixer un alliage de soudure comprend l'étape consistant à fixer un alliage de soudure de 80/20 Au/Sn.

11. Procédé selon la revendication 9, dans lequel l'étape consistant à mettre en prise de manière étanche comprend en outre l'étape consistant à refaire écouler l'alliage de soudure sans l'aide d'un flux.

12. Procédé selon la revendication 9, dans lequel l'étape consistant à mettre en prise de manière étanche comprend l'étape consistant à sceller hermétiquement l'emballage (10) en refaisant écouler l'alliage de soudure dans un environnement inerte sans l'aide d'un flux.

13. Emballage (10) avec un dispositif formant relais micromagnétique de verrouillage (15) hermétiquement scellé dans l'emballage, comprenant :
un substrat de support à base d'arséniure de gallium (12) avec une surface ;
au moins un contact (17, 18) pour le dispositif formant relais micromagnétique de verrouillage (15) sur la surface du substrat de support (12) avec un raccordement externe (14) sur le contact (17, 18) et un porte-à-faux (16) sur la surface du substrat de support (12), le porte-à-faux (16) étant positionné pour se déplacer en mise en prise électrique avec le contact (17, 18) dans une orientation ;
une bague d'étanchéité métallique (20A) fixée sur la surface du substrat de support (12) de manière circonférentielle autour du contact (17, 18), et du porte-à-faux (16), la bague d'étanchéité (20A) comprenant une partie d'adhésion et une partie d'étanchéité ;
une puce de silicium formant un élément de capuchon (22) avec une cavité et définissant une cavité avec un bord continu de manière circonférentielle autour de la cavité, la cavité étant conçue pour recevoir le porte-à-faux (16) et le contact (17, 18) à l'intérieur de celle-ci ;
une bague d'étanchéité métallique (20B) fixée sur le bord continu de l'élément de capuchon (22), la bague d'étanchéité métallique (20B) comprenant une partie d'adhésion et une partie d'étanchéité ;
un aimant (24) fixé sur l'élément de capuchon (22) ; et
un alliage de soudure mettant en prise de manière étanche la bague d'étanchéité métallique (20B) sur le bord continu de l'élément de capuchon (22), avec la bague d'étanchéité métallique (20A) sur la surface du substrat de support (12).

14. Emballage scellé selon la revendication 13, dans lequel la partie d'adhésion comprend l'un parmi le tungstène, le titane et leurs combinaisons.

15. Emballage scellé selon la revendication 13, dans lequel la partie d'étanchéité comprend l'un parmi le nickel, l'or, le chrome et leurs alliages.

16. Emballage scellé selon la revendication 13, dans lequel l'alliage de soudure comprend un alliage de soudure de 80/20 Au/Sn.

17. Emballage selon la revendication 13, dans lequel l'emballage est hermétiquement scellé en refaisant écouler l'alliage de soudure dans un environnement inerte sans l'aide d'un flux.
